(19) Europäisches Patentamt
European Patent Office
Office européen des brevets

(11) Veröffentlichungsnummer: **0 283 764 B1**

(12) # EUROPÄISCHE PATENTSCHRIFT

(45) Veröffentlichungstag der Patentschrift: **29.05.91**

(51) Int. Cl.[5]: **C08F 230/08**, C08F 212/14, //(C08F230/08,212:14), (C08F212/14,230:08)

(21) Anmeldenummer: **88103002.7**

(22) Anmeldetag: **29.02.88**

(54) **Alkenylphenol- und Alkenylphenolether-Copolymere.**

(30) Priorität: **11.03.87 DE 3707843**

(43) Veröffentlichungstag der Anmeldung: **28.09.88 Patentblatt 88/39**

(45) Bekanntmachung des Hinweises auf die Patenterteilung: **29.05.91 Patentblatt 91/22**

(84) Benannte Vertragsstaaten: **DE FR GB IT NL SE**

(56) Entgegenhaltungen: **US-A- 3 125 554**

(73) Patentinhaber: **Siemens Aktiengesellschaft**
**Wittelsbacherplatz 2**
**W-8000 München 2(DE)**

(72) Erfinder: **Sezi, Recai, Dr.**
**Weiherstrasse 14**
**W-8551 Röttenbach(DE)**
Erfinder: **Birkle, Siegfried, Dr.**
**Veit-Stoss-Strasse 46**
**W-8552 Höchstadt(DE)**
Erfinder: **Feucht, Hans-Dieter, Dr.**
**Eschenweg 7**
**W-7253 Renningen 2(DE)**

**EP 0 283 764 B1**

Anmerkung: Innerhalb von neun Monaten nach der Bekanntmachung des Hinweises auf die Erteilung des europäischen Patents kann jedermann beim Europäischen Patentamt gegen das erteilte europäische Patent Einspruch einlegen. Der Einspruch ist schriftlich einzureichen und zu begründen. Er gilt erst als eingelegt, wenn die Einspruchsgebühr entrichtet worden ist (Art. 99(1) Europäisches Patentübereinkommen).

**Beschreibung**

Die Erfindung betrifft neue Alkenylphenol-Copolymere bzw. deren Ether, und zwar Copolymere aus Alkenylphenolen bzw. Alkenylphenolethern und Alkenylsilanen.

Die neuen Verbindungen sind Alkenylphenol-Alkenylsilan-Copolymere bzw. deren Ether der allgemeinen Formel

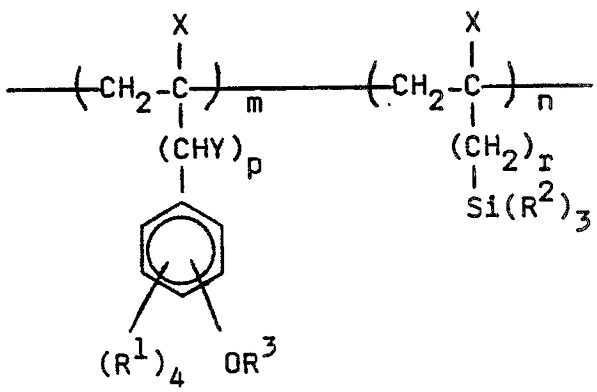

,

worin m + n = 1 ist, p und r jeweils 0, 1 oder 2 bedeuten (und zwar unabhängig voneinander), und für die Reste X, Y, $R^1$, $R^2$ und $R^3$ folgendes gilt:

X = H, $CH_3$, $C_2H_5$ oder Halogen (d.h. F, Cl, Br, J),
Y = H, $CH_3$ oder Halogen,
$R^1$ = H, Halogen, Alkyl (d.h. $CH_3$ und $C_2H_5$) oder Halogenalkyl,
$R^2$ = H, $CH_3$, $C_2H_5$, $C_3H_7$ oder $C_6H_5$,
$R^3$ = H oder R*,
wobei R* folgende Bedeutung hat:
$CH_3$, $C_2H_5$, $C_3H_7$, $CH(CH_3)_2$, $C(CH_3)_3$, $C_6H_{11}$, $C_6H_5$, $CH_2C_6H_5$, $CH_2OCH_3$, $CH_2OCH_2CH_2OCH_3$, $Si(CH_3)_3$ und $Si(CH_3)_2C(CH_3)_3$,

und wobei die Reste X, $R^1$ und $R^2$ jeweils gleich oder verschieden sein können.

In der vorstehenden Formel geben m und n die Zusammensetzung der Copolymeren als Stoffmengenanteil (Molenbruch) an. Der Anteil der Komponente m, d.h. des Alkenylphenol(ether)-Grundbausteins, liegt dabei etwa im Bereich zwischen 0,99 und 0,01.

Insbesondere betrifft die Erfindung Vinylphenol-Vinylsilan-Copolymere bzw. deren Ether der allgemeinen Formel

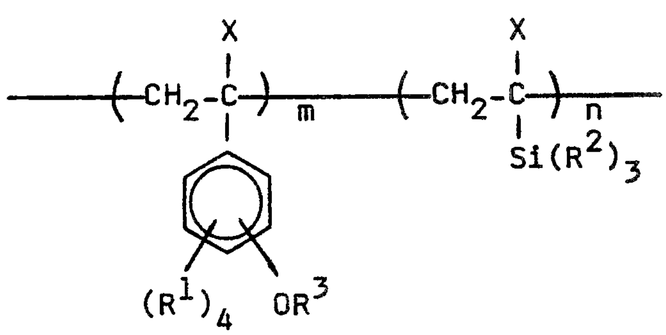

,

worin m + n = 1 ist, und X, $R^1$, $R^2$ und $R^3$ die vorstehend angegebene Bedeutung haben.

Bevorzugte Verbindungen sind Copolymere aus Vinylphenol, insbesondere p-Vinylphenol, und Vinyltrimethylsilan. Weitere Verbindungen sind beispielsweise Copolymere mit Vinyltriethylsilan, Vinyldiethylmethylsilan, Vinyldimethylethylsilan, Vinyldimethylphenylsilan, Allyltrimethylsilan, Allyltriethylsilan, Allyldiethylmethylsilan, Allyldimethylethylsilan und Allyldimethylphenylsilan.

Die neuen Vinylverbindungen werden durch ionische Copolymerisation von Vinylphenolethern mit nicht-hydrolysierbaren Vinylsilanen hergestellt; die entsprechenden Vinylphenol-Copolymeren entstehen daraus durch Spaltung der Ethergruppen. Bei der Etherspaltung entstehen aus den Ethergruppen (-OR*) Hydroxylgruppen (-OH).

Bevorzugt werden zur Copolymerisation als Vinylphenolether die o-, m- oder p-Isomeren von Methoxystyrol, Ethoxystyrol, Propoxystyrol, Isopropoxystyrol, t-Butoxystyrol, Phenoxystyrol und Benzyloxystyrol eingesetzt. Die Copolymerisation selbst erfolgt im Falle der Vinylverbindungen im allgemeinen mittels bekannter ionischer Initiatoren, vorzugsweise mittels anionischer Initiatoren. Beispiele für derartige Initiatoren sind Butyllithium und Naphthalinkalium. Der Anteil des Vinylsilan-Bausteins im Copolymer kann bei der anionischen Polymerisation durch Variation der Reaktionsprameter, wie Molverhältnis der Monomeren, Lösungsmittel und Initiator, gezielt gesteuert werden.

Die Copolymerisation kann aber auch radikalisch durchgeführt werden; im Falle von Allyl- (p und/oder r = 1) und Butenylverbindungen (p und/oder r = 2) erfolgt sie bevorzugt in dieser Weise. Dabei dienen zur Initiierung Radikalbildner, wie Azoisobutyronitril und Peroxide. Bei der radikalischen Copolymerisation werden mit Vinylsilanen Copolymere mit einem geringen Anteil (< 10 Mol-%) an Vinylsilan-Monomer erhalten.

Die Copolymerisation erfolgt im allgemeinen in unpolaren aprotischen organischen Lösungsmitteln, insbesondere in aliphatischen oder aromatischen Lösungsmitteln, wie Heptan und Toluol. Die Reaktionstemperatur kann im Bereich zwischen -100 und +100 °C liegen. Die Umsetzung verläuft mit guten Ausbeuten. Die Ausbeute kann bis auf 100 % gesteigert werden, wenn bei der Copolymerisation der Initiatorlösung katalytische Mengen eines Ethers oder eines tertiären Amins zugesetzt werden; dabei bleiben die Produkteigenschaften im übrigen unverändert. Beispiele derartiger Initiatorgemische sind:

- n-Butyllithium in Heptan mit Zusatz von Tetrahydrofuran (Molverhältnis von n-BuLi:THF = 1:1);
- n-Butyllithium in Hexan mit Zusatz von Tetramethylethylendiamin (Molverhältnis 1:1).

Die Spaltung der Ethergruppen erfolgt ebenfalls im aprotischen Medium. Zur Etherspaltung werden dabei Lewis-Säuren, wie Bortribromid, eingesetzt. Die beim Spaltprozeß entstehenden Hydroxylgruppen verleihen den erfindungsgemäßen Copolymeren eine Alkalilöslichkeit. Zum Schutz der Hydroxylgruppen während der Polymerisation sind aber nicht nur Ethergruppen, sondern allgemein solche Gruppen geeignet, die unter den jeweiligen Polymerisationsbedingungen stabil sind und nach der Copolymerisation wieder abgespalten werden können. Neben Ethergruppen sind dies beispielsweise Estergruppen (siehe dazu: T.W. Greene, "Protective Groups in Organic Synthesis", John Wiley & Sons, New York, 1981, Seiten 87 bis 113 und Seiten 152 bis 192).

Die erfindungsgemäßen Vinylphenol-Vinylsilan-Copolymeren zeichnen sich durch eine gute Löslichkeit in verschiedenen organischen Lösungsmitteln, wie Alkoholen, Ketonen und Estern, aus. Diese Copolymeren weisen ferner eine hohe Erweichungstemperatur und gute Filmbildungseigenschaften auf. Aufgrund der Ätzbeständigkeit im Sauerstoffplasma, der Verträglichkeit mit photoreaktiven Komponenten bzw. Lösungsinhibitoren und der guten Alkalilöslichkeit eignen sich die erfindungsgemäßen Copolymeren insbesondere als Basispolymer für trockenätzbeständige, hochauflösende Resists für UV-, DUV (Deep UV)-, Elektronen-und Röntgenstrahlen. Derartige Resists sind Gegenstand der gleichzeitig eingereichten europäischen Patentanmeldung Nr. 88103001.9, "Verfahren zur Erzeugung von Resiststrukturen" (siehe : EP-A-0285797).

Anhand von Beispielen soll die Erfindung noch näher erläutert werden.

Beispiel 1

In einen sorgfältig getrockneten Zweihals-Glaskolben mit aufgesetztem Gaseinleitungsrohr werden unter trockenem, sauerstofffreiem Inertgasstrom, beispielsweise Stickstoff, nacheinander 26,8 g (200 mmol) von Inhibitoren befreites, über $CaH_2$ destilliertes p-Methoxystyrol, 10 g (100 mmol) frisch destilliertes Vinyltrimethylsilan, 34 ml absolutes Toluol und 1,1 g (17 mmol) n-Butyllithium (in Hexan) unter Rühren gegeben, und der Kolben wird dann sofort mit einem mit Paraffinöl gefüllten Rückschlagventil verschlossen. Anschließend wird der Kolben in einen auf 25 °C temperierten Thermostaten eingebracht. Nach 20 h wird die Polymerisation durch Zugabe von 1 bis 2 ml Methanol abgebrochen, die Reaktionslösung in einen Tropftrichter gegeben und unter kräftigem Rühren langsam in das zehnfache Volumen Methanol getropft. Das dabei als weiße flockige Masse ausfallende Reaktionsprodukt wird abfiltriert und bei 50 °C im Vakuum-Trockenschrank bis zur Gewichtskonstanz getrocknet; Ausbeute: 16,56 g (45 % der Theorie). Das auf diese Weise erhaltene Copolymer besteht zu 58 Mol-% aus Methoxystyrol- und zu 42 Mol-% aus Vinyltrimethylsilan-Grundbausteinen.

In einem trockenen Dreihals-Rundkolben mit Innenthermometer, Rührer und Kühler mit Trockenrohr werden 10 g des in der vorstehend beschriebenen Weise hergestellten Copolymers in 150 ml trockenem

Dichlormethan gelöst und in einem Kältebad auf ca. -80 °C abgekühlt. Danach gibt man langsam eine ebenfalls auf -80 °C gekühlte Lösung von 16,2 g Bortribromid in 50 ml trockenem Dichlormethan zu und läßt die Reaktionslösung, innerhalb von drei Stunden, unter Rühren auf Raumtemperatur erwärmen. Die Lösung färbt sich dabei rotbraun. Sie wird dann mit ca. 5 ml Wasser versetzt und stark gerührt, wobei sich eine klebrige, an der Flüssigkeitsoberfläche schwimmende Masse bildet. Nach Zugabe von 100 ml 10%iger Natronlauge löst sich die klebrige Masse in der wäßrig-alkalischen Phase auf. Die organische Phase wird im Scheidetrichter von der NaOH-Phase getrennt und 2 bis 3 mal mit NaOH gewaschen. Die vereinigten NaOH-Extrakte werden mit Salzsäure angesäuert, in Ethylacetat aufgenommen, mit destilliertem Wasser gewaschen, über Natriumsulfat getrocknet und mit einer zehnfachen Menge an Petrolether ausgefällt. Das dabei erhaltene Produkt wird im Vakuum-Trockenschrank bei 50 °C bis zur Gewichtskonstanz getrocknet; Ausbeute: 7,07 g (76 % der Theorie).

Das erhaltene Copolymer aus p-Vinylphenol und Vinyltrimethylsilan ist außer in Natronlauge und Ethylacetat auch in Cyclohexanon und 2-Ethoxyethylacetat löslich. Das osmometrisch ermittelte Molekulargewicht beträgt 2400, die durch Gelpermeationschromatographie bestimmte Einheitlichkeit 1,2. Das Copolymer erweicht (im beheizten Mikroskop) bei ca. 155 °C. Aus dem NMR-Spektrum geht hervor, daß die Etherspaltung quantitativ verlaufen ist.

Beispiel 2

Entsprechend Beispiel 1 werden in einen Kolben nacheinander 26,8 g (200 mmol) von Inhibitoren befreites, über $CaH_2$ destilliertes p-Methoxystyrol, 20 g (200 mmol) frisch destilliertes Vinyltrimethylsilan, 44 ml absolutes Heptan und 1,4 g (22 mmol) n-Butyllithium (in Form einer 1,6 molaren Lösung in Hexan) gegeben und in der dort angegebenen Weise bei 25 °C polymerisiert. Nach 6 h wird die Polymerisation durch Zugabe von 2 ml Methanol abgebrochen, dann wird die Reaktionslösung in einen Tropftrichter gegeben und unter kräftigem Rühren langsam in das zehnfache Volumen Methanol getropft. Das dabei ausfallende Reaktionsprodukt wird abfiltriert und bei 50 °C im Vakuum-Trockenschrank bis zur Gewichtskonstanz getrocknet; Ausbeute: 15 g (32 % der Theorie). Das auf diese Weise erhaltene Copolymer enthält 45 Mol-% Methoxystyrol und 55 Mol-% Vinyltrimethylsilan.

Die nachfolgende Etherspaltung wird entsprechend Beispiel 1 durchgeführt. Dabei werden pro Mol Methoxystyrol 1 bis 1,3 Mol Bortribromid eingesetzt. Die Ausbeute beträgt 84 % der Theorie, bezogen auf die isolierte Menge an Copolymer aus p-Vinylphenol und Vinyltrimethylsilan. Dem NMR-Spektrum ist zu entnehmen, daß die Etherspaltung quantitativ erfolgt ist. Das Copolymer hat ein Molekulargewicht von 5000 (osmometrisch ermittelt), und ist in Natronlauge (2n), 2-Ethoxyethylacetat und Cyclohexanon löslich. Unter dem beheizten Mikroskop wird bis 200 °C kein Erweichen festgestellt.

Beispiel 3

Entsprechend Beispiel 1 werden in einen Kolben nacheinander 13,4 g (100 mmol) von Inhibitoren befreites, über $CaH_2$ destilliertes p-Methoxystyrol, 10 g (100 mmol) frisch destilliertes Vinyltrimethylsilan, 22 ml absolutes Tetrahydrofuran und 0,7 g (11 mmol) n-Butyllithium (in Form einer 1,6 molaren Lösung in Hexan) gegeben und in der dort angegebenen Weise bei 25 °C polymerisiert. Nach 6 h wird die Polymerisation durch Zugabe von 1 ml Methanol abgebrochen, dann wird die Reaktionslösung in einen Tropftrichter gegeben und unter kräftigem Rühren langsam in das zehnfache Volumen Methanol getropft. Das dabei flockig ausfallende Reaktionsprodukt wird abfiltriert, mit Methanol gewaschen und im Vakuum-Trockenschrank bei 50 °C bis zur Gewichtskonstanz getrocknet; Ausbeute: 5,6 g (24 % der Theorie). Das auf diese Weise erhaltene Copolymer besteht zu 85 Mol-% aus Methoxystyrol und zu 15 Mol-% aus Vinyltrimethylsilan.

Die nachfolgende Etherspaltung wird entsprechend Beispiel 1 durchgeführt. Die Ausbeute beträgt 75 % der Theorie, bezogen auf die isolierte Menge an Copolymer. Das Copolymer aus p-Vinylphenol und Vinyltrimethylsilan ist in Natronlauge (2n), Cyclohexanon und 2-Ethoxyethylacetat löslich, das osmometrisch ermittelte Molekulargewicht beträgt 1400. Das NMR-Spektrum zeigt, daß die Etherspaltung quantitativ verlaufen ist.

Beispiel 4

Entsprechend Beispiel 1 werden in einen Kolben nacheinander 5,7 g (43 mmol) von Inhibitoren befreites, über $CaH_2$ destilliertes p-Methoxystyrol, 4,3 g (43 mmol) frisch destilliertes Vinyltrimethylsilan und 22 ml absolutes Tetrahydrofuran gegeben. Der verschlossene Kolben wird dann in einen auf -60 °C temperierten Thermostaten eingebracht. Nach 1 h, wenn die Innentemperatur des Kolbens -60 °C erreicht hat, werden unter Rühren 0,14 g (0,86 mmol) Naphthalinkalium zugegeben. Nach 16 h wird die Polymerisation durch Zugabe von 1 ml Methanol abgebrochen, die Reaktionslösung in einen Tropftrichter gegeben und unter kräftigem Rühren langsam in das zehnfache Volumen Methanol getropft. Das dabei flockig ausfallende Reaktionsprodukt wird abfiltriert, mit Methanol gewaschen und im Vakuum-Trockenschrank bei 50 °C bis zur Gewichtskonstanz getrocknet; Ausbeute: 6,4 g (64 % der Theorie). Das erhaltene Copolymer besteht aus 79 Mol-% Methoxystyrol- und 21 Mol-% Vinyltrimethylsilan-Grundbausteinen.

Die nachfolgende Etherspaltung wird entsprechend Beispiel 1 durchgeführt. Die Ausbeute beträgt 85 % der Theorie, bezogen auf die isolierte Menge an Copolymer. Das Copolymer aus p-Vinylphenol und Vinyltrimethylsilan ist in Natronlauge (2n), Cyclohexanon und 2-Ethoxyethylacetat löslich.

Beispiel 5

Entsprechend Beispiel 1 werden in einen Kolben nacheinander 138 g (1,03 Mol) von Inhibitoren befreites, über $CaH_2$ destilliertes p-Methoxystyrol, 77 g (0,77 Mol) frisch destilliertes Vinyltrimethylsilan und 280 ml absolutes Toluol gegeben. Der verschlossene Kolben wird dann in einen auf 0 °C temperierten Thermostaten eingebracht. Nach 1 h werden unter Rühren 11,5 g (0,18 Mol) n-Butyllithium (in Hexan) zugegeben. Nach 70 h wird die Polymerisation durch Zugabe von 10 ml Methanol abgebrochen, die Reaktionslösung in einen Tropftrichter gegeben und unter kräftigem Rühren langsam in das zehnfache Volumen Methanol getropft. Das dabei als weiße, klebrige Masse ausfallende Reaktionsprodukt wird abfiltriert und bei 50 °C im Vakuum-Trockenschrank bis zur Gewichtskonstanz getrocknet; Ausbeute: 176 g (82 % der Theorie). Das auf diese Weise erhaltene Copolymer besteht aus 54 Mol-% Methoxystyrol- und 46 Mol-% Vinyltrimethylsilan-Grundbausteinen.

In einem Dreihals-Rundkolben (siehe dazu Beispiel 1) werden unter Inertgas 160 g des in der vorstehend beschriebenen Weise hergestellten Copolymers in 2 l trockenem Dichlormethan gelöst und in einem Kältebad auf ca. -60 °C abgekühlt. Danach gibt man langsam eine nicht gekühlte Lösung von 240 g Bortribromid in 200 ml trockenem Dichlormethan zu und läßt die Reaktionslösung, innerhalb von drei Stunden, unter Rühren auf Raumtemperatur erwärmen. Die Lösung färbt sich dabei gelblich. Sie wird dann mit ca. 90 ml Wasser versetzt und stark gerührt, wobei sich eine klebrige, an der Flüssigkeitsoberfläche schwimmende Masse bildet. Nach Zugabe von 2 l 10 %iger Natronlauge löst sich die klebrige Masse in der wäßrig-alkalischen Phase auf. Die organische Phase wird im Scheidetrichter von der NaOH-Phase getrennt und 2 bis 3 mal mit NaOH gewaschen. Die vereinigten NaOH-Extrakte werden mit Salzsäure angesäuert, in Ethylacetat aufgenommen, mit destilliertem Wasser gewaschen, über Natriumsulfat getrocknet und mit einer zehnfachen Menge an Petrolether ausgefällt. Das dabei erhaltene Produkt wird im Vakuum-Trockenschrank bei 50 °C bis zur Gewichtskonstanz getrocknet; Ausbeute: 129 g (86 % der Theorie).

Das erhaltene Copolymer aus p-Vinylphenol und Vinyltrimethylsilan ist außer in Natronlauge und Ethylacetat auch in Cyclohexanon und 2-Ethoxyethylacetat löslich. Das osmometrisch ermittelte Molekulargewicht beträgt 2600, die durch Gelpermeationschromatographie bestimmte Einheitlichkeit 1,2. Das Copolymer erweicht (im beheizten Mikroskop) bei ca. 155 °C. Aus dem NMR-Spektrum geht hervor, daß die Etherspaltung quantitativ verlaufen ist.

## Ansprüche

1. Alkenylphenol- und Alkenylphenolether-Alkenylsilan-Copolymere der allgemeinen Formel

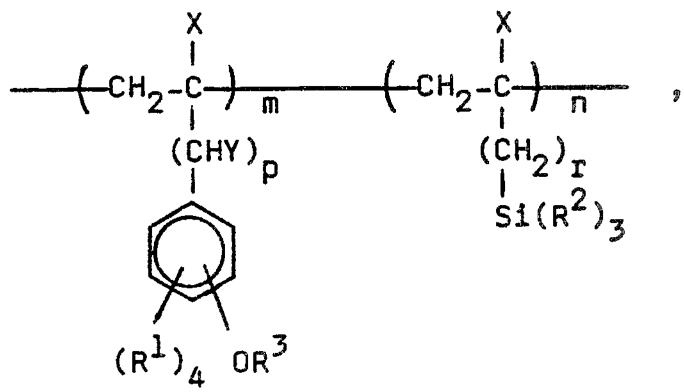

worin m + n = 1 (Molenbruch) ist, p und r jeweils 0, 1 oder 2 bedeuten (und zwar unabhängig voneinander),
und für die Reste X, Y, $R^1$, $R^2$ und $R^3$ folgendes gilt:

X = H, $CH_3$, $C_2H_5$ oder Halogen (d.h. F, Cl, Br, J),
Y = H, $CH_3$ oder Halogen,
$R^1$ = H, Halogen, Alkyl (d.h. $CH_3$ und $C_2H_5$) oder Halogenalkyl,
$R^2$ = H, $CH_3$, $C_2H_5$, $C_3H_7$ oder $C_6H_5$,
$R^3$ = H oder R*,
wobei R* folgende Bedeutung hat:
$CH_3$, $C_2H_5$, $C_3H_7$, $CH(CH_3)_2$, $C(CH_3)_3$, $C_6H_{11}$, $C_6H_5$, $CH_2C_6H_5$, $CH_2OCH_3$, $CH_2OCH_2CH_2OCH_3$, $Si(CH_3)_3$ und $Si(CH_3)_2C(CH_3)_3$,
und wobei die Reste X, $R^1$ und $R^2$ jeweils gleich oder verschieden sein können.

**2.** Vinylphenol- und Vinylphenolether-Vinylsilan-Copolymere der allgemeinen Formel

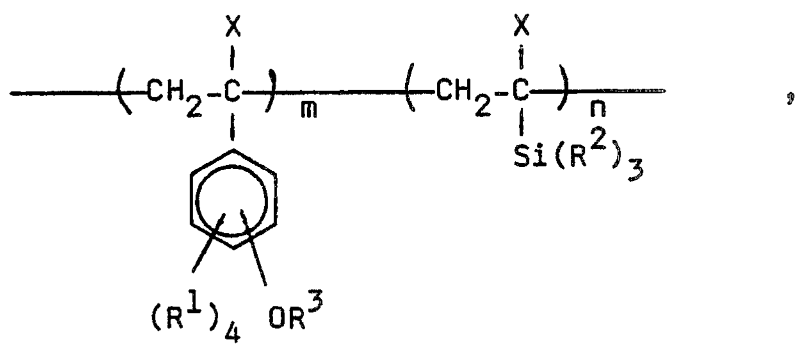

worin m + n = 1 ist, und X, $R^1$, $R^2$ und $R^3$ wie in Anspruch 1 definiert sind.

**3.** Vinylphenol-Vinyltrimethylsilan-Copolymerisat.

## Claims

**1.** Alkenyl phenol and alkenyl phenolether alkenyl silane copolymers of the general formula

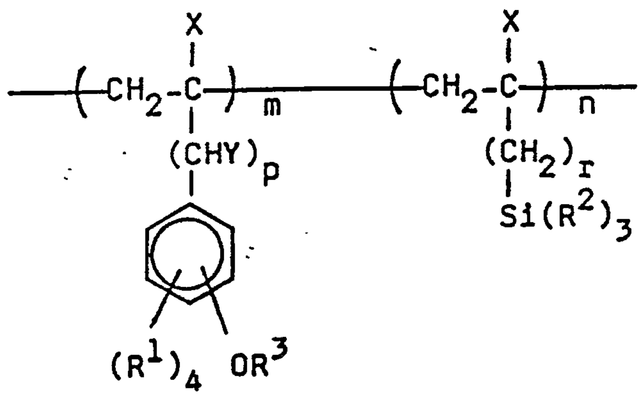

wherein m + n (as mole fractions) = 1, p and r in each case signify 0, 1 or 2 (and indeed independently of one another),
and for the rest X, Y, $R^1$, $R^2$ and $R^3$ the following applies;
X = H, $CH_3$, $C_2H_5$ or halogen (i.e. F, Cl, Br, I),
Y = H, $CH_3$ or halogen,
$R^1$ = H, halogen, alkyl (i.e. $CH_3$ and $C_2H_5$) or haloalkyl,
$R^2$ = H, $CH_3$, $C_2H_5$, $C_3H_7$ or $C_6H_5$,
$R^3$ = H or $R^*$;
whereby $R^*$ has the following significance:
$CH_3$, $C_2H_5$, $C_3H_7$, $CH(CH_3)_2$, $C(CH_3)_3$, $C_6H_{11}$, $C_6H_5$, $CH_2C_6H_5$, $CH_2OCH_3$, $CH_2OCH_2CH_2OCH_3$, $Si(CH_3)_3$ and $Si(CH_3)_2C(CH_3)_3$,
and whereby the rest X, $R^1$ and $R^2$ can be the same or different respectively.

2. Vinyl phenol and vinylphenolether vinyl silane copolymers of the general formula

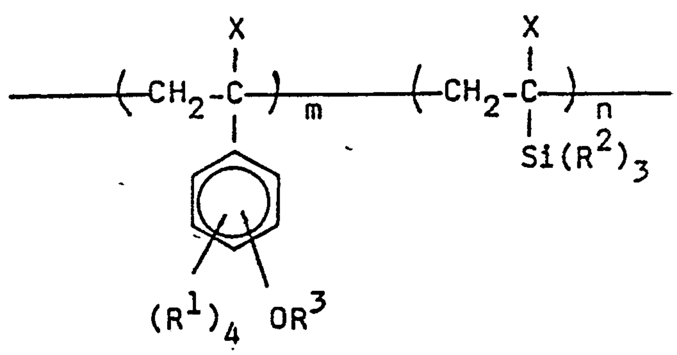

wherein m + n = 1, and X, $R^1$, $R^2$ and $R^3$ are defined as in claim 1.

3. Vinyl phenol vinyl trimethylsilane copolymer.

## Revendications

1. Copolymère d'alcénylsilanes et d'alcénylphénols ou d'étheroxydes d'alcénylphénol de formule développée

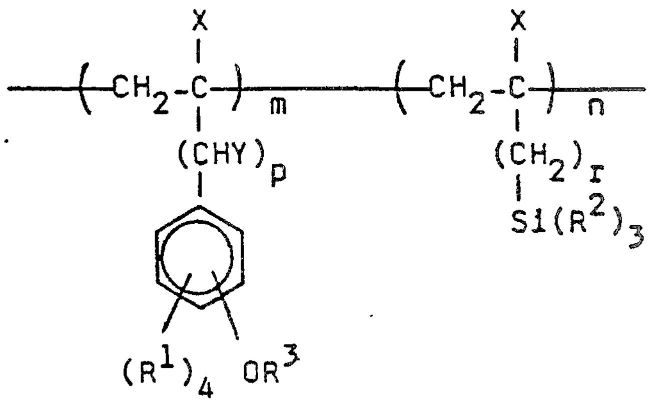

,

dans laquelle m + n = 1 (fraction molaire), p et r signifient respectivement 0, 1 ou 2 (et cela indépendamment les uns des autres),
et pcur les radicaux X, Y, $R^1$, $R^2$ et $R^3$, on a les significations suivantes :

X = H, $CH_3$, $C_2H_5$ ou halogène (c'est-à-dire F, Cl, Br, I),
Y = H, $CH_3$ ou halogène,
$R^1$ = H, halogène, alcoyle (c'est-à-dire $CH_3$ et $C_2H_5$) ou haloalcoyle,
$R^2$ = H, $CH_3$, $C_2H_5$, $C_3H_7$ ou $C_6H_5$,
$R^3$ = H ou $R^*$,
$R^*$ ayant la signification suivante :
$CH_3$, $C_2H_5$, $C_3H_7$, $CH(CH_3)_2$, $C(CH_3)_3$, $C_6H_{11}$, $C_6H_5$, $CH_2C_6H_5$, $CH_2OCH_3$, $CH_2OCH_2CH_2OCH_3$, $Si(CH_3)_3$ et $Si(CH_3)_2C(CH_3)_3$,
les radicaux X, $R^1$ et $R^2$ pouvant être identiques ou différents.

2. Copolymère de vinylsilane et de vinylphénol ou d'étheroxydes de vinylphénol de formule développée

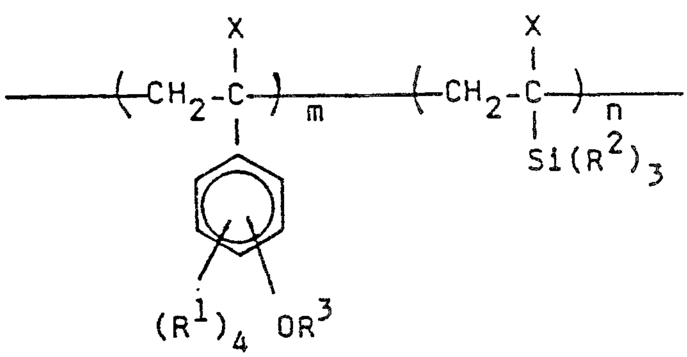

,

dans laquelle m + n = 1, et X, $R^1$, $R^2$ et $R^3$ sont définis comme à la revendication 1.

3. Copolymère de vinylphénol et de vinyltriméthylsilane.